# EUROPEAN PATENT SPECIFICATION

(11) **EP 3 190 505 B1**
(45) Date of publication and mention of the grant of the patent: **11.11.2020**
(21) Application number: 17150438.4
(22) Date of filing: 05.01.2017
(51) Int. Cl.: G06F 3/16, H04N 21/485, H03G 3/02, G06F 3/0481, H04M 1/725, G06F 3/0484, H03G 3/00

(54) **METHOD FOR OUTPUTTING SOUND AND ELECTRONIC DEVICE SUPPORTING THE SAME**
VERFAHREN FÜR DIE AUSGABE VON TON UND ELEKTRONISCHE VORRICHTUNG ZUR UNTERSTÜTZUNG DAVON
PROCÉDÉ PERMETTANT L'ÉMISSION D'UN SON ET DISPOSITIF ÉLECTRONIQUE L'EXÉCUTANT

(30) Priority: 05.01.2016 KR 20160001131
(43) Date of publication of application: 12.07.2017
(73) Proprietor: Samsung Electronics Co., Ltd., Gyeonggi-do 16677 (KR)
(72) Inventor: Jeong, Jin Hong, 16909 Yongin-si (KR); Choi, Bo Kun, 08090 Seoul (KR)
(74) Representative: Nederlandsch Octrooibureau

(56) References cited:
- EP-A1- 2 447 828
- EP-A2- 2 615 805
- WO-A1-2014/201863
- US-A1- 2014 082 496
- US-A1- 2015 253 936

## Description

### BACKGROUND OF THE INVENTION

### 1. Field of the Invention

The present disclosure relates generally to a method for providing a user with a sound that is output according to an execution of an application and an electronic device supporting the same, and more particularly, to a method for providing a user with a sound that is output according to an execution of an application which includes storing a sound output method based on at least one or more applications executing in the electronic device or categories of the applications, and an electronic device supporting the same.

### 2. Background of the Invention

Electronic devices such as smartphones and tablet personal computers (PCs) are able to perform various functions including a voice call, a video call, a wireless data communication, and a media output. An electronic device may execute various applications and may output various sounds based on the execution of the applications.

An electronic device may execute a plurality of applications at the same time when supporting multi-tasking. In this case, an electronic device may simultaneously output sounds, which may be output from a plurality of applications, through an internal speaker or an external speaker. For example, an electronic device may output a sound (e.g., a background sound or a sound effect) that is based on an execution of a game application or app and a sound (e.g., a sound source playback) that is based on an execution of a music playback app at the same time.

Since a conventional sound output method uniformly outputs various sounds, which are generated in an electronic device, through one output device (e.g., an internal speaker or an external speaker), the method fails to separately control the output of sounds for each application. In this case, since a user listens to a sound that the user wants to listen to together with a sound that the user does not want to listen to, the user may listen to a sound of a form such as complex noise.

The user may adjust a level of an output sound or turn the sound on/off through an internal setting of each application, but the user may fail to adjust sound output characteristics in an electronic device jointly or may fail to select a sound output device.

The above information is presented as background information only to assist with an understanding of the present disclosure. No determination has been made, and no assertion is made, as to whether any of the above might be applicable as prior art with regard to the present disclosure.

EP 2 615 805 A2 discloses that the controller of the mobile terminal controls a sound source to correspond to a specific output device. For example, the sound source associated with the navigation application may be output through the speaker, the sound source associated with the MPS application may be output through the earphone, and the sound source associated with a call may be output through the Bluetooth earphone. By outputting a specific sound source to a specific output device, the user may control the output device so as to be optimized for the current (play) environment.

The device of US 2015/253936 A1 displays a multimedia interface on a display screen, the interface comprising a number of multimedia programs operating on different audio sources. The user controls the state of the multimedia feature (volume) of the multimedia program through the interface.

EP 2 447 828 A1 discloses that a user can change a master volume level for changing the volume levels of each of the software applications, and when one of the software applications is at a maximum volume level, the user may increase the master volume level for increasing the volume levels of each of the other software applications which are not at the maximum level.

### SUMMARY OF THE INVENTION

The invention is as defined by independent claims. Particular embodiments of the invention are present in the dependent claims.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a block diagram of an electronic device in a network environment, according to an embodiment of the present disclosure;
FIG. 2 is a flowchart of a sound output method, according to an embodiment of the present disclosure;
FIGS. 3A and 3B are illustrations of screens for setting a sound output method that is based on an application, according to an embodiment of the present disclosure;
FIGS. 4A-4C are illustrations of screens for controlling a sound output method through a plurality of access procedures, according to an embodiment of the present disclosure;
FIGS. 5A and 5B are illustrations of screens for setting a sound output method that is based on a category of an application, according to an embodiment of the present disclosure;
FIG. 6 is a flowchart of a process in which an electronic device operates in conjunction with a plurality of external devices, according to an embodiment of the present disclosure;
FIG. 7 is an illustration of an electronic device operating with a plurality of external devices, according to an embodiment of the present disclosure;
FIG. 8 is an illustration of a screen for storing a sound output method in each external output device, according to an embodiment of the present disclosure;
FIG. 9 is a flowchart of a process of changing a sound output method in a multi-window screen, according to an embodiment of the present disclosure;
FIGS. 10A-10C are illustrations of screens indicating a change of a sound output method in a multi-window screen, according to an embodiment of the present disclosure;
FIGS. 11A and 11B are illustrations of screens indicating a change of a sound output method by selecting an area in a multi-window screen, according to an embodiment of the present disclosure;
FIGS. 12A and 12B are illustrations of screens indicating a change of a sound output method in a multi-window screen of a picture-in-picture (PIP) manner, according to an embodiment of the present disclosure;
FIG. 13 is a flowchart of a process a plurality of applications outputting sounds, according to an embodiment of the present disclosure;
FIG. 14 is a block diagram of an electronic device, according to an embodiment of the present disclosure; and
FIG. 15 is a block diagram of a program module, according to an embodiment of the present disclosure.
Throughout the drawings, it should be noted that like reference numbers are used to depict the same or similar elements, features, and structures.

### DETAILED DESCRIPTION OF EMBODIMENTS OF THE PRESENT INVENTION

The following description with reference to the accompanying drawings is provided to assist in a comprehensive understanding of various embodiments of the present disclosure as defined by the claims. It includes various specific details to assist in that understanding but these are to be regarded as merely exemplary. Accordingly, those of ordinary skill in the art will recognize that various changes and modifications of the various embodiments described herein can be made without departing from the scope of the present disclosure. In addition, descriptions of well-known functions and constructions may be omitted for clarity and conciseness.

When an element (for example, a first element) is referred to as being "(operatively or communicatively) coupled with/to" or "connected to" another element (for example, a second element), the element may be directly coupled with/to or connected to the other element or an intervening element (for example, a third element) may be present. In contrast, when an element (for example, a first element) is referred to as being "directly coupled with/to" or "directly connected to" another element (for example, a second element), there are no intervening element (for example, a third element).

According to the situation, the expression "configured to" used herein may be used interchangeably with, for example, the expression "suitable for", "having the capacity to", "designed to", "adapted to", "made to", or "capable of'. The term "configured to (or set to)" does not indicate only "specifically designed to" in hardware. Instead, the expression "a device configured to" may indicate that the device is "capable of' operating together with another device or other components. A central processing unit (CPU), for example, a "processor configured to (or set to) perform A, B, and C" may indicate a dedicated processor (for example, an embedded processor) for performing a corresponding operation or a general purpose processor (for example, a CPU or an application processor) which may perform corresponding operations by executing one or more software programs which are stored in a memory device.

Terms in this specification are used to describe certain embodiments of the present disclosure but are not intended to limit the scope of the present disclosure. The terms of a singular form may include plural forms unless otherwise specified. Unless otherwise defined herein, all the terms used herein, may have the same meanings that are generally understood by a person skilled in the art. Terms, which are defined in a dictionary and commonly used, are intended to be interpreted as is customary in the relevant related art and not in an idealized or overly formal manner unless expressly so defined herein in various embodiments of the present disclosure. In some cases, even if terms are defined in the present disclosure, they are not intended to be interpreted to exclude embodiments of the present disclosure.

An electronic device according to various embodiments of the present disclosure may include at least one of smartphones, tablet PCs, mobile phones, video telephones, electronic book readers, desktop PCs, laptop PCs, netbook computers, workstations, servers, personal digital assistants (PDAs), portable multimedia players (PMPs), MP3 players, mobile medical devices, cameras, and wearable devices. Wearable devices may include accessories (for example, watches, rings, bracelets, ankle bracelets, glasses, contact lenses, or head-mounted devices (HMDs)), cloth-integrated types (for example, electronic clothes), body-attached types (for example, skin pads or tattoos), or implantable types (for example, implantable circuits).

In some embodiments of the present disclosure, an electronic device may be one of home appliances. Home appliances may include, for example, at least one of a digital video disk (DVD) player, an audio player, a refrigerator, an air conditioner, a cleaner, an oven, a microwave oven, a washing machine, an air cleaner, a set-top box, a home automation control panel, a security control panel, a TV box (for example, Samsung HomeSync®, Apple TV®, or Google TVTM), a game console (for example, Xbox® or PlayStation®), an electronic dictionary, an electronic key, a camcorder, or an electronic panel.

In another embodiment of the present disclosure, an electronic device may include at least one of various medical devices (for example, various portable medical measurement devices (e.g., a blood glucose meter, a heart rate measuring device, a blood pressure measuring device, and a body temperature measuring device), a magnetic resonance angiography (MRA) device, a magnetic resonance imaging (MRI) device, a computed tomography (CT) device, a camera, and an ultrasonic device), a navigation system, a global navigation satellite system (GNSS), an event data recorder (EDR), a flight data recorder (FDR), a vehicular infotainment device, electronic devices for vessels (for example, a navigation device for vessels and a gyro compass), avionics, a security device, a vehicular head unit, an industrial or home robot, an automated teller machine (ATM) of a financial company, a point of sale (POS) device of a store, or an Internet of Things (IoT) device (for example, a light bulb, various sensors, an electricity or gas meter, a sprinkler device , a fire alarm, a thermostat, an electric pole, a toaster, a sporting apparatus, a hot water tank, a heater, and a boiler).

According to some embodiments of the present disclosure, an electronic device may include at least one of furniture or a part of a building/structure, an electronic board, an electronic signature receiving device, a projector, or various measurement devices (for example, a water, electricity, gas, or electrical wave measuring device). An electronic device may be one or a combination of the aforementioned devices. An electronic device may be a flexible electronic device. Further, an electronic device is not limited to the aforementioned devices, but may include electronic devices subsequently developed.

Hereinafter, electronic devices according to an embodiment of the present disclosure will be described with reference to the accompanying drawings. The term "user" used herein may refer to a person who uses an electronic device or a device (for example, an artificial intelligence electronic device) that uses an electronic device.

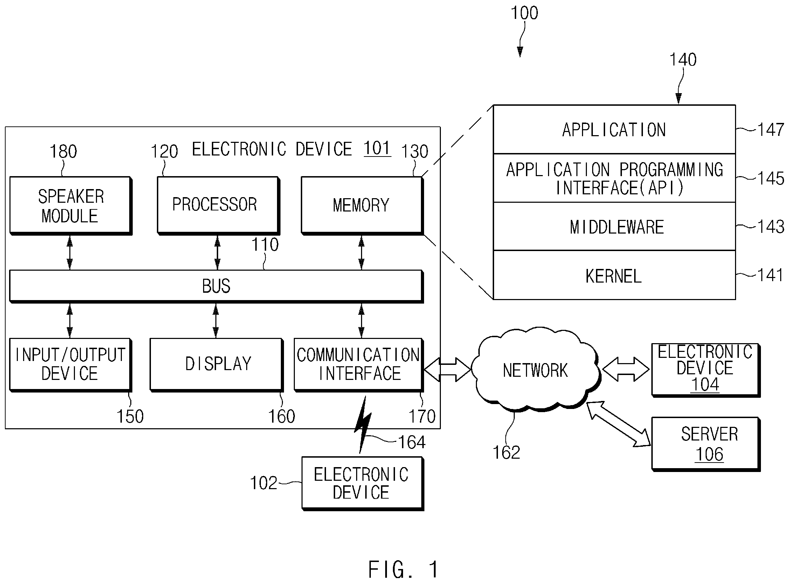

FIG. 1 is a block diagram of an electronic device 101 in a network environment 100, according to an embodiment of the present disclosure.

Referring to FIG. 1, there is illustrated an electronic device 101 in a network environment 100 according to an embodiment of the present disclosure. The electronic device 101 may include a bus 110, a processor 120, a memory 130, an input/output (I/O) device 150, a display 160, and a communication interface 170. The electronic device 101 might not include at least one of the above-described elements or may further include other element(s).

For example, the bus 110 may interconnect the above-described elements 120 to 170 and may include a circuit for conveying communications (e.g., a control message and/or data) among the above-described elements 120-170.

The processor 120 may include one or more of a CPU, an application processor (AP), or a communication processor (CP). The processor 120 may perform, for example, data processing or an operation associated with control and/or communication of at least one other element(s) of the electronic device 101.

In an embodiment of the present disclosure, the processor 120 may control a method to output sound that is generated by executing an application installed in the electronic device 101. The processor 120 may individually set a sound output characteristic (e.g., sound output level, sound tone, or the like) or a sound output device (e.g., an internal speaker or an external speaker) based on each application (or a category of each application) installed in the electronic device 101. The processor 120 may provide a user with a user interface (UI) screen for setting a sound output method of an application.

The memory 130 may include a volatile and/or a nonvolatile memory. For example, the memory 130 may store instructions or data associated with at least one other element(s) of the electronic device 101.

According to an embodiment of the present disclosure, the memory 130 may store information about a sound output method of each application. For example, the memory 130 may store a list of applications that is to be output through an internal speaker of the electronic device 101. The processor 120 may refer to the list of applications in a case where each application is executing.

According to an embodiment of the present disclosure, the memory 130 may store software and/or a program 140. The program 140 may include, for example, a kernel 141, a middleware 143, an application programming interface (API) 145, and/or an application program (or "application") 147. At least a part of the kernel 141, the middleware 143, or the API 145 may be referred to as an operating system (OS).

The kernel 141 may control or manage system resources (e.g., the bus 110, the processor 120, the memory 130, and the like) that are used to execute operations or functions of other programs (e.g., the middleware 143, the API 145, and the application program 147). Furthermore, the kernel 141 may provide an interface that allows the middleware 143, the API 145, or the application program 147 to access discrete elements of the electronic device 101 so as to control or manage system resources.

The middleware 143 may perform a mediation role such that the API 145 or the application program 147 communicates with the kernel 141 to exchange data.

Furthermore, the middleware 143 may process one or more task requests received from the application program 147 according to a priority. For example, the middleware 143 may assign a priority, which makes it possible to use a system resource (e.g., the bus 110, the processor 120, the memory 130, or the like) of the electronic device 101, to at least one of the application program 147. For example, the middleware 143 may process one or more task requests according to a priority assigned to the at least one or more task requests, which makes it possible to perform scheduling or load balancing on the one or more task requests.

The API 145 may be an interface through which the application 147 controls a function provided by the kernel 141 or the middleware 143, and may include, for example, at least one interface or function (e.g., an instruction) for file control, window control, image processing, character control, or the like.

The I/O device 150 may transmit an instruction or data, input from a user or another external device, to other element(s) of the electronic device 101. Furthermore, the I/O device 150 may output an instruction or data, received from other element(s) of the electronic device 101, to a user or another external device.

The display 160 may include, for example, a liquid crystal display (LCD), a light-emitting diode (LED) display, an organic LED (OLED) display, a microelectromechanical systems (MEMS) display, or an electronic paper display. The display 160 may display, for example, various kinds of content (e.g., text, an image, a video, an icon, a symbol, and the like) to a user. The display 160 may include a touch screen and may receive, for example, a touch, gesture, proximity, or hovering input using an electronic pen or a portion of a user's body.

According to an embodiment of the present disclosure, the display 160 may output the UI screen for setting a sound output method (or information of outputting sound) of an application. A user may change a sound output method (e.g., an output level, a speaker device through which a sound is to be output, and the like) of an application by using a corresponding UI screen.

The communication interface 170 may establish communication between the electronic device 101 and an external device (e.g., a first external electronic device 102, a second external electronic device 104, or a server 106). For example, the communication interface 170 may be connected to a network 162 through wireless communication or wired communication to communicate with the second external electronic device 104 or the server 106.

Wireless communication may include at least one of, for example, long-term evolution (LTE), LTE advance (LTE-A), code division multiple access (CDMA), wideband CDMA (WCDMA), universal mobile telecommunications system (UMTS), wireless broadband (WiBro), or global system for mobile communication (GSM), or the like, as a cellular communication protocol. Furthermore, wireless communication may include, for example, a local area network 164. The local area network 164 may include at least one of wireless fidelity (Wi-Fi), near field communication (NFC), magnetic stripe transmission (MST), a global navigation satellite system (GNSS), or the like.

MST may generate a pulse in response to transmission data using an electromagnetic signal, and the pulse may generate a magnetic field signal. The electronic device 101 may transfer a magnetic field signal to a POS device, and a POS device may detect a magnetic field signal using an MST reader. The POS device may recover data by converting a detected magnetic field signal to an electrical signal.

GNSS may include at least one of, for example, a global positioning system (GPS), a global navigation satellite system (Glonass), a Beidou navigation satellite system (Beidou), or an European global satellite-based navigation system (Galileo), based on an available region, a bandwidth, or the like. In the present disclosure, the terms "GPS" and "GNSS" may be used interchangeably.

Wired communication may include at least one of, for example, a universal serial bus (USB), a high definition multimedia interface (HDMI), a recommended standard 232 (RS-232), a plain old telephone service (POTS), or the like. The network 162 may include at least one of telecommunication networks, for example, a computer network (e.g., a local area network (LAN) or a wide area network (WAN)), an Internet, or a telephone network.

The speaker module 180 may be an internal speaker mounted in the electronic device 101. The speaker module 180 may output a sound that is generated by an application executing in the electronic device 101. In an embodiment of the present disclosure, a sound that is output through the speaker module 180 may be individually set for each application. For example, a sound of a first application may be output through the speaker module 180, but a sound of a second application might not be output through the speaker module 180.

Each of the first and second external electronic devices 102 and 104 may be a device of which the type is different from or the same as that of the electronic device 101. According to an embodiment of the present disclosure, the server 106 may include a group of one or more servers. All or a portion of operations that the electronic device 101 may perform may be executed by another or plural electronic devices (e.g., the electronic devices 102 and 104 or the server 106). In a case where the electronic device 101 executes any function or service automatically or in response to a request, the electronic device 101 might not perform the function or the service internally, but the electronic device 101 may request at least a part of a function associated with the electronic device 101 to be performed by another device (e.g., the electronic device 102 or 104 or the server 106). Another electronic device (e.g., the electronic device 102 or 104 or the server 106) may execute a requested function or an additional function and may transmit an execution result to the electronic device 101. The electronic device 101 may provide a requested function or service using a received result or may additionally process a received result to provide the requested function or service. To this end, for example, cloud computing, distributed computing, or client-server computing may be used.

According to an embodiment of the present disclosure, the first and second external electronic devices 102 and 104 may be external electronic devices (e.g., external Bluetooth speakers) that operate in conjunction with the electronic device 101 using a certain communication protocol (e.g., Bluetooth). The first and second external electronic devices 102 and 104 may output different sounds based on a kind of application executing in the electronic device 101.

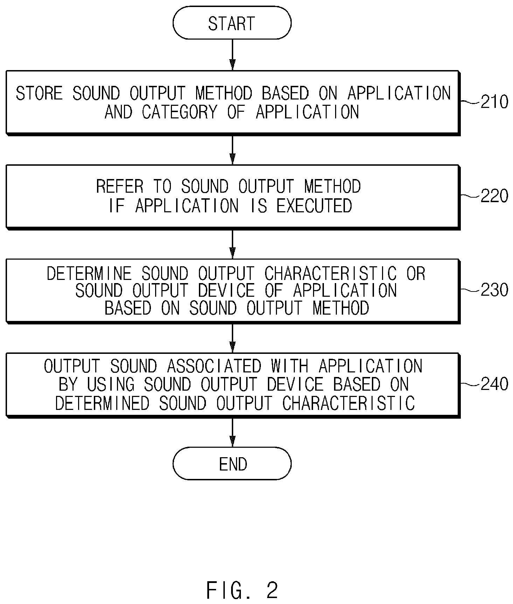

FIG. 2 is a flowchart of a sound output method, according to an embodiment of the present disclosure.

Referring to FIG. 2, in step 210, the processor 120 may store a sound output method that is based on each application executing in the electronic device 101 or a category of each application in the memory 130. The sound output method may include information about sound output characteristics (e.g., sound output level, sound tone, and the like) or sound output devices (e.g., an internal speaker, an external speaker, and the like).

According to an embodiment of the present disclosure, the processor 120 may output a UI screen for setting a sound output method that is based on each application or a category of each application. The processor 120 may store the sound output method of the application, based on a user input.

In step 220, if the application is executing in the electronic device 101, the processor 120 may refer to the sound output method stored in the memory 130. The processor 120 may search a database for the sound output method stored in the memory 130, based on identification information of the executing or running application.

In step 230, the processor 120 may determine the sound output characteristic or the sound output device of the running application, based on the stored sound output method. For example, the processor 120 may determine whether to output a sound, a sound output level, a sound tone, and the like, based on the sound output characteristic and may determine whether to output a sound through an internal speaker of the electronic device 101 or whether to output the sound by sending a sound source signal to an external speaker.

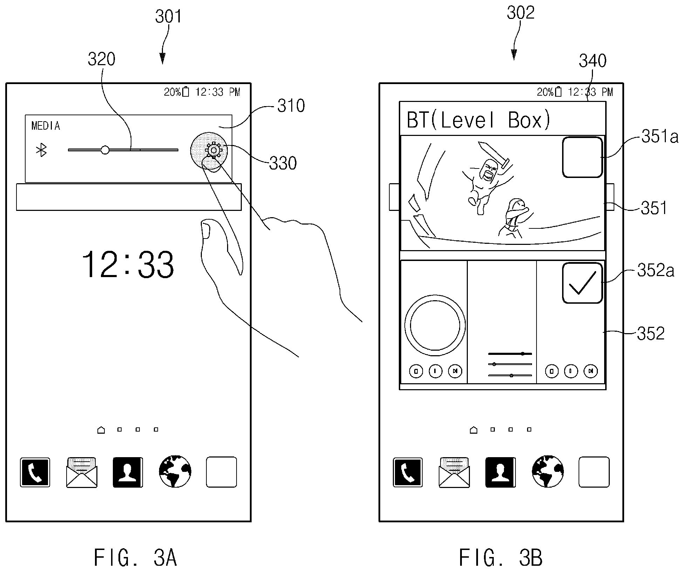

In step 240, the processor 120 may output a sound associated with the running application through the sound output device, based on the determined sound output characteristic. In an embodiment of the present disclosure, in a case where a plurality of applications are being executed in the electronic device 101, the processor 120 may set sound output methods of the applications such that the applications have different sound output methods. For example, a sound of a first application may be output through an internal speaker of the electronic device 101, and a sound of a second application may be output through an external speaker. The processor 120 may provide a UI screen for setting a sound output method that is based on each application or a category of each application. A method to output a sound of an application is described below with reference to FIGS. 3A to 15.

FIGS. 3A and 3B are illustrations of screens for setting a sound output method that is based on an application, according to an embodiment of the present disclosure. However, the present disclosure is not limited thereto.

Referring to FIGS. 3A and 3B, in a screen 301, the processor 120 may output a setting window 310 for controlling a sound output method associated with an application. The setting window 310 may be output when an event, such as a user input, an external device recognition, or the like, occurs. For example, the setting window 310 may be displayed when an external speaker (e.g., a Bluetooth speaker) is recognized.

A user may control sounds of all applications executing in the electronic device 101 by moving a bar 320 included in the setting window 310. For example, in a case where a user moves the bar 320 to the left, volumes of sounds of the applications, which are output through the external speaker (e.g., a Bluetooth speaker) connected through a wireless connection, may each be reduced simultaneously. In contrast, in a case where a user moves the bar 320 to the right, the volumes of sounds of the applications, which are output from the external speaker (e.g., a Bluetooth speaker), may each be increased simultaneously. The user may individually set the sound output method, which is based on an application, by touching a button 330.

If a user selects the button 330, in a screen 301, the processor 120 may output a setting window 340, in screen 302, for controlling the sound output for each application. The setting window 340 may display a list of applications that are executable in the electronic device 101. In an embodiment of the present disclosure, at a point in time when the setting window 340 is output, the processor 120 may display a list of applications that are being executed in the electronic device 101 or a list of applications having a sound output function.

A user may change a sound output method of each application in the setting window 340. The processor 120 may store a sound output method of each application in response to a user input. If a corresponding application is executing, the processor 120 may output a sound of the application with reference to a stored sound output method.

For example, the setting window 340 may output a list that includes a first application (e.g., a game app) 351 and a second application (e.g., a music playback app) 352, which are currently executing. The first application 351 may be displayed together with a check box 351a. If the check box 351a is not selected, a sound source associated with the first application 351 may not be output. Similarly, the second application 352 may be displayed together with a check box 352a. If the check box 352a is not selected, a sound source associated with the second application 352 may not be output.

In an embodiment of the present disclosure, in a case where the check box 351a or the check box 352a is checked, the processor 120 may output a movable bar for controlling a sound output level of each application or advanced setting items such as an equalizer and the like.

In FIGS. 3A and 3B, there is illustrated a method to turn on/off the sound output of each application by using the check box 351a or the check box 352a. However, the present disclosure is not limited thereto. For example, the processor 120 may output an additional option button for each application, and an additional setting window if a user presses the additional option button.

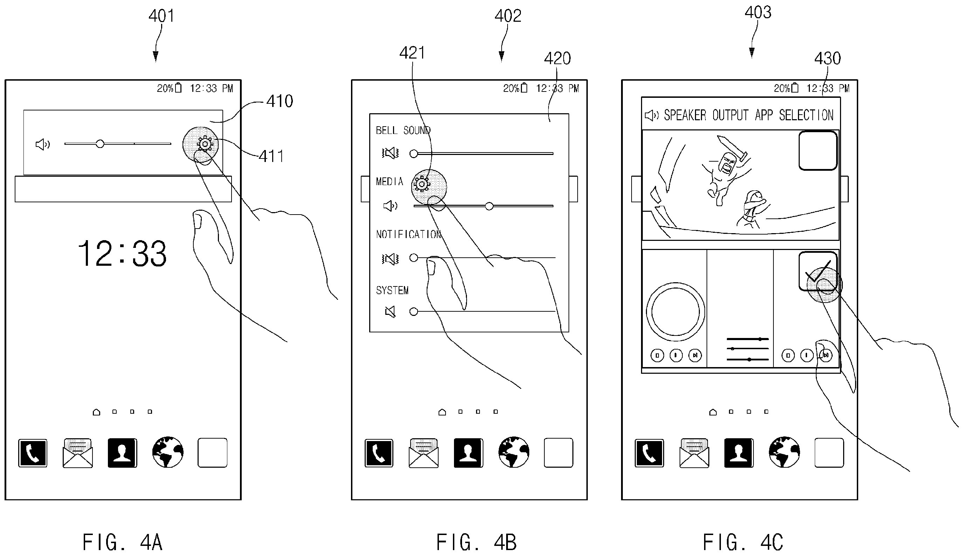

FIGS. 4A-4C are illustrations of screens for controlling a sound output method through a plurality of access procedures, according to an embodiment of the present disclosure. However, the present disclosure is not limited thereto.

Referring to FIGS. 4A-4C, in a screen 401 of FIG. 4A, the processor 120 may output a setting window 410 1) in a case where a user presses an external volume button of the electronic device 101 or 2) in a case where a user selects a sound setting item when setting the electronic device 101. A user may set all the sound output levels of the electronic device 101 by moving a bar included in the setting window 410.

In a case where a user selects a button 411, in screen 401, included in the setting window 410, there may be output a setting window 420, in screen 402 of FIG. 4B, for controlling sounds that are outputted from the electronic device 101 in connection with categories such as a bell sound, media, a notification sound, a system, and the like.

If a user presses a button 421 included in the setting window 420 to set a sound output method associated with media playback, in a screen 402, the processor 120 may output a setting window 430, in screen 403, for controlling the sound output for each application.

In a screen 403 of FIG. 4C, the processor 120 may output the setting window 430 for controlling a sound output method for each application. A user may change a sound output method of each application in the setting window 430. The processor 120 may store a sound output method of each application, based on a user input. If a corresponding application is executing, the processor 120 may output a sound of the application with reference to a stored sound output method. For example, if a user does not select a check box of a game app, a sound of a corresponding game app may not be output through an internal speaker. A method to operate the setting window 430 may be the same as or similar to a method to operate the setting window 340 in FIG. 3B.

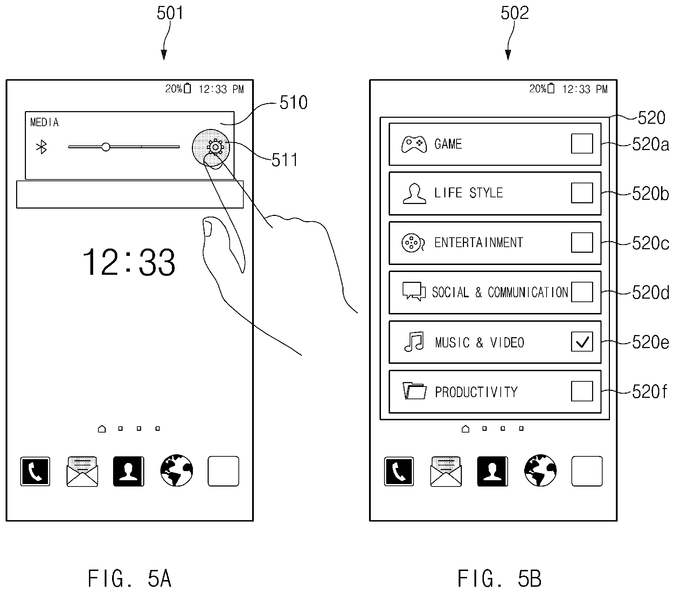

FIGS. 5A and 5B are illustrations of screens for setting a sound output method that is based on a category of an application, according to an embodiment of the present disclosure. However, the present disclosure is not limited thereto.

Referring to FIGS. 5A and 5B, in a screen 501, the processor 120 may output a setting window 510 for controlling a sound output method. For example, the setting window 510 may be displayed when an external speaker (e.g., a Bluetooth speaker) is recognized. A user may touch a button 511 to set a sound output method that is based on a category of an application.

If a user selects the button 511, in a screen 501, the processor 120 may output a setting window 520, in screen 502, for controlling the sound output for each application category. A category of an application may be determined according to attributes of the application installed in the electronic device 101. In an embodiment of the present disclosure, a category may be the same as a category of an application applied to an app market (e.g., Google play, an app store). Categories 520a to 520f of FIG. 5B are examples, not limiting embodiments of the present disclosure.

The setting window 520 may display a category list of applications that are executable in the electronic device 101. In an embodiment of the present disclosure, at a point in time when the setting window 340 is output, the processor 120 may display a category list associated with an application that is running in the electronic device 101 or may output a category list that includes an application having a sound output function.

A user may change a sound output method of an application in the setting window 520 in units of a category. The processor 120 may store the sound output method in units of an application category. If an application is executing, the processor 120 may output a sound of the running application with reference to a sound output method of a category of the running application.

For example, a user may restrict a sound output of a game category 520a between the game category 520a and a music and video category 520e, which are frequently used, through an external speaker and may permit a sound output of the music and video category 520e through the external speaker. As such, a user may listen to music through an external speaker operating with the electronic device 101 while playing a game through a display of the electronic device 101. Since a sound associated with the game application is not output through the external speaker operating with the electronic device 101, the user may concentrate on listening to music through the external speaker.

In an embodiment of the present disclosure, the setting window 520, in screen 502, may output a list that includes the categories 520a to 520f of applications executable in the electronic device 101. Each category may be displayed together with a check box. If a check box is not selected, the sound source associated with the application included in the corresponding category may not be output through the corresponding output device (e.g., a Bluetooth speaker).

In an embodiment of the present disclosure, in a case where check boxes associated with the categories 520a to 520f are checked off, the processor 120 may output a moving bar for controlling the sound output level of each category or advanced setting items such as an equalizer and the like.

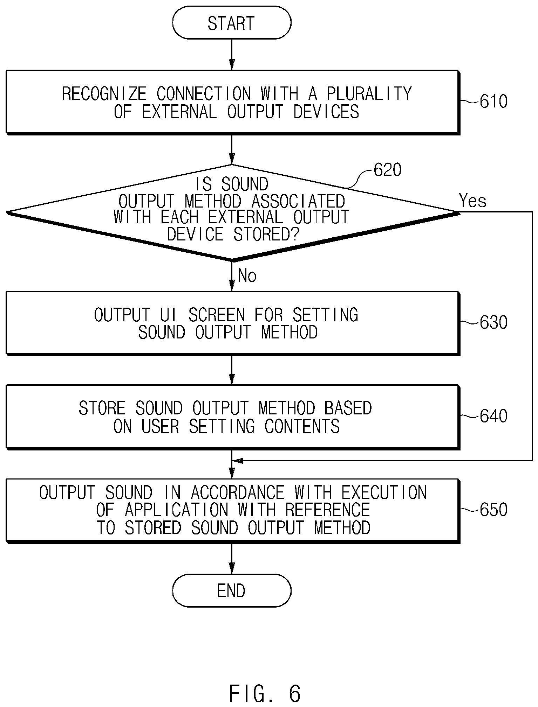

FIG. 6 is a flowchart of a process in which an electronic device operates in conjunction with a plurality of external devices, according to an embodiment of the present disclosure.

Referring to FIG. 6, in step 610, the processor 120 may recognize a connection with a plurality of external output devices (e.g., Bluetooth speakers) through the communication interface 170. A case where a plurality of external output devices operate in conjunction with the electronic device 101 through the local area network (e.g., Bluetooth communication) is described below. However, the present disclosure is not limited thereto.

In step 620, the processor 120 may verify whether a sound output method associated with each external output device is stored in the memory 130.

If the sound output method associated with a corresponding external output device is not stored in advance, in step 630, the processor 120 may output a UI screen for setting the sound output method.

If a user sets a sound output method associated with an external output device through a UI screen, in step 640, the processor 120 may store a sound output method based on the setting contents.

In step 650, the processor 120 may output a sound, which is generated according to the execution of an application, with reference to a stored sound output method.

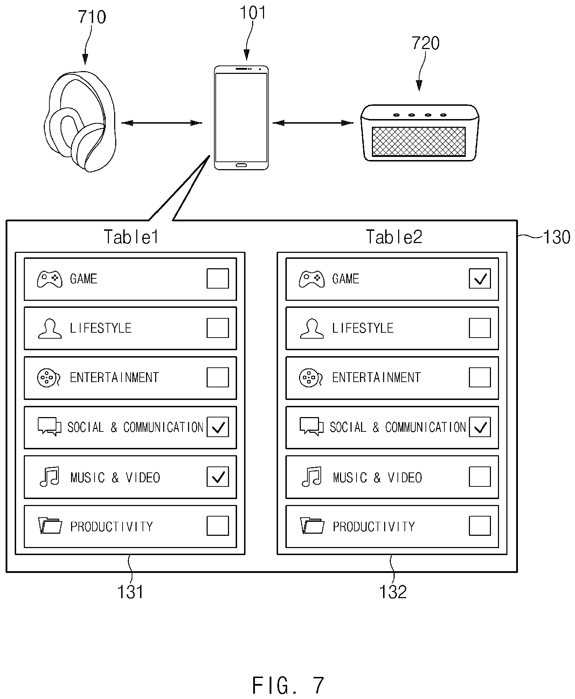

FIG. 7 is an illustration of an electronic device operating with a plurality of external devices, according to an embodiment of the present disclosure.

Referring to FIG. 7, the electronic device 101 may, respectively, operate in conjunction with a first external output device 710 (e.g., a Bluetooth headset) and a second external output device 720 (e.g., a Bluetooth speaker). Each of the first external output device 710 and the second external output device 720 may include a wired/wireless communication module and may be wirelessly connected with the electronic device 101 by using a certain communication protocol (e.g., a Bluetooth communication). The electronic device 101 may transmit a sound source signal of a running application to the first external output device 710 and the second external output device 720. Each of the first external output device 710 and the second external output device 720 may output a sound, based on the received sound source signal.

According to an embodiment of the present disclosure, in a case where the electronic device 101 executes the same application, the first external output device 710 and the second external output device 720 may output different sounds. The processor 120 may provide a user with a UI screen for setting a sound output method of each of the external output devices 710 and 720. The user may determine an application to be output through each of the external output devices 710 and 720 through the UI screen.

According to an embodiment of the present disclosure, in a case where the processor 120 recognizes a connection with the first external output device 710, the processor 120 may provide a user with a setting screen including a first table 131. The user may verify a list of applications or a category list of applications included in the first table 131 and may select an application or a category of each application that outputs a sound through the first external output device 710. The processor 120 may store setting contents of the first table 131 in the internal memory 130 of the electronic device 101.

The processor 120 may refer to the first table 131 when an application is executing in the electronic device 101. A sound source signal of the application permitted by the first table 131 may be transmitted to the first external output device 710.

The first external output device 710 may output a sound corresponding to the received sound source signal. In FIG. 7, the first table 131 includes a category list of applications. However, the present disclosure is not limited thereto. For example, the first table 131 may include a list of applications that are currently running in the electronic device 101.

As in the above description, in a case where the processor 120 recognizes the connection with the second external output device 720, the processor 120 may provide a user with a setting screen including a second table 132. The user may verify a list of applications or a category list of applications included in the second table 132 and may select an application or a category of each application that outputs a sound through the second external output device 720. The processor 120 may store setting contents of the second table 132 in the internal memory 130 of the electronic device 101.

For example, in a case where first to third applications are simultaneously executing in the electronic device 101, a sound associated with the first application (e.g., a music playback app) may be output through the first external output device 710 but may not be output through the second external output device 720. A sound associated with the second application (e.g., a game app) may be output through the second external output device 720 but may not be output through the first external output device 710. A sound associated with the third application (e.g., a social networking service (SNS) app) may be output through the first external output device 710 and the second external output device 720.

According to an embodiment of the present disclosure, in a case where the processor 120 recognizes a connection with the first external output device 710 or the second external output device 720, the processor 120 may verify whether a table that is associated with a sound output for the corresponding external output device is stored. If a table that is associated with a sound output for the corresponding external output device was stored, the processor 120 may output a sound based on the sound output table, which is stored in advance, without providing a user with a separate sound setting screen.

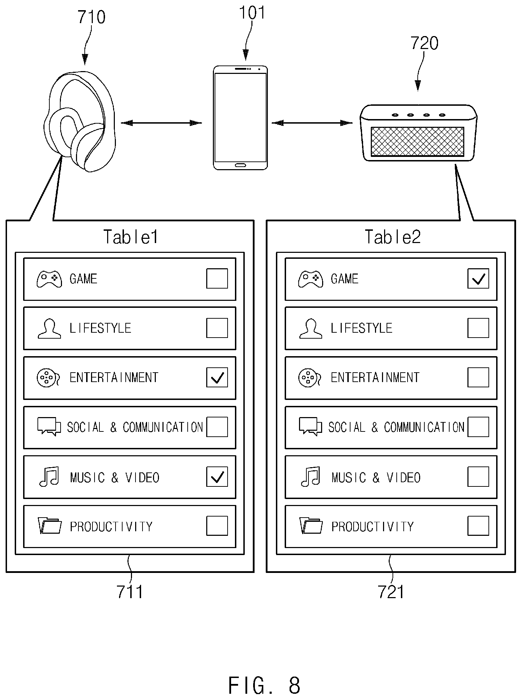

FIG. 8 is an illustration of a screen for storing a sound output method in each external output device, according to an embodiment of the present disclosure. However, the present disclosure is not limited thereto.

Referring to FIG. 8, the electronic device 101 may operate with the first external output device 710 (e.g., a Bluetooth headset) and the second external output device 720 (e.g., a Bluetooth speaker). The first external electronic device 710 and the second external electronic device 720 may output a sound, based on a sound source signal received from the electronic device 101.

According to an embodiment of the present disclosure, unlike the description above of FIG. 7, the first external electronic device 710 and the second external electronic device 720 may store a list of applications or a category list of applications, which are capable of generating a sound, in the corresponding output device.

In a case where the electronic device 101 recognizes the first external output device 710, the electronic device 101 may receive a first table 711 associated with the sound output from the first external output device 710. The electronic device 101 may determine a sound output method of a running application with reference to the first table 711. For example, the electronic device 101 may output a sound of an application that corresponds to an entertainment category or a music & video category, which is permitted in the first table 711, through the first external output device 710 but may not output a sound, which is generated by an application belonging to another category, through the first external output device 710.

According to an embodiment of the present disclosure, in a case where the first external output device 710 is connected to the electronic device 101, the electronic device 101 may output the first table 711 received from the first external output device 710 to a user. The user may select an application (or a category of an application), which will be output through the first external output device 710, in the first table 711. The electronic device 101 may transmit the updated first table 711 to the first external output device 710. The first external output device 710 may store the updated first table 711.

As in the above-described manner, in a case where the electronic device 101 recognizes the second external output device 720, the electronic device 101 may receive a second table 721 associated with the sound output from the second external output device 720. The electronic device 101 may determine a sound output method of a running application with reference to the second table 721.

According to an embodiment of the present disclosure, in a case where the second external output device 720 is connected to the electronic device 101, the electronic device 101 may output the second table 721 received from the second external output device 720 to a user. The electronic device 101 may transmit the second table 721 updated by the user to the second external output device 720. The second external output device 720 may store the updated second table 721.

According to an embodiment of the present disclosure, the first external output device 710 and the second external output device 720 may store sound output related tables (e.g., the first table 711 or the second table 721) in internal memories thereof and may operate in the same sound output method even though an electronic device (e.g., a smartphone, a tablet PC) operating therewith is changed. For example, in a case where a user makes use of the first external output device 710 in conjunction with a second electronic device (e.g., a tablet PC) after stop using the first external output device 710 in conjunction with a first electronic device (e.g., a smartphone), the first electronic device (e.g., a smartphone) and the second electronic device (e.g., a tablet PC) may output only a sound associated with an application of the same category, based on the same first table 711 stored in the first external output device 710.

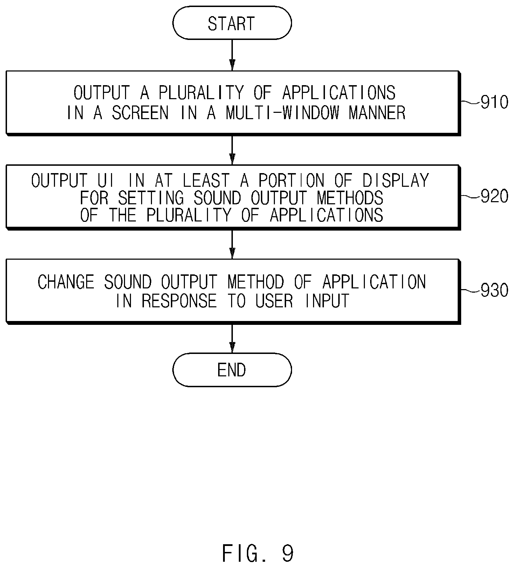

FIG. 9 is a flowchart of a process of changing a sound output method in a multi-window, according to an embodiment of the present disclosure.

Referring to FIG. 9, in step 910, the processor 120 may output a plurality of applications in a screen in a multi-window manner. For example, the processor 120 may output an execution screen of a first application in a first area (or a first window) (e.g., an upper area of a screen) of the display 160 and may output an execution screen of a second application in a second area (or a second window) (e.g., a lower area of the screen) of the display 160.

In step 920, the processor 120 may output a UI for setting the sound output methods of a plurality of running applications in at least a portion of the display 160. In the above-described example, the processor 120 may output a button for setting the sound output method between the first area in which the first application is executing and the second area in which the second application is executing.

If the processor 120 receives a user input to change a sound output method of at least one of the plurality of applications, in step 930, the processor 120 may change a sound output method of an application in response to the input.

In the above-described example, in a case where the user touches the button, the processor 120 may change a sound output method of at least one of the plurality of applications, based on a number of times that the user touches the button.

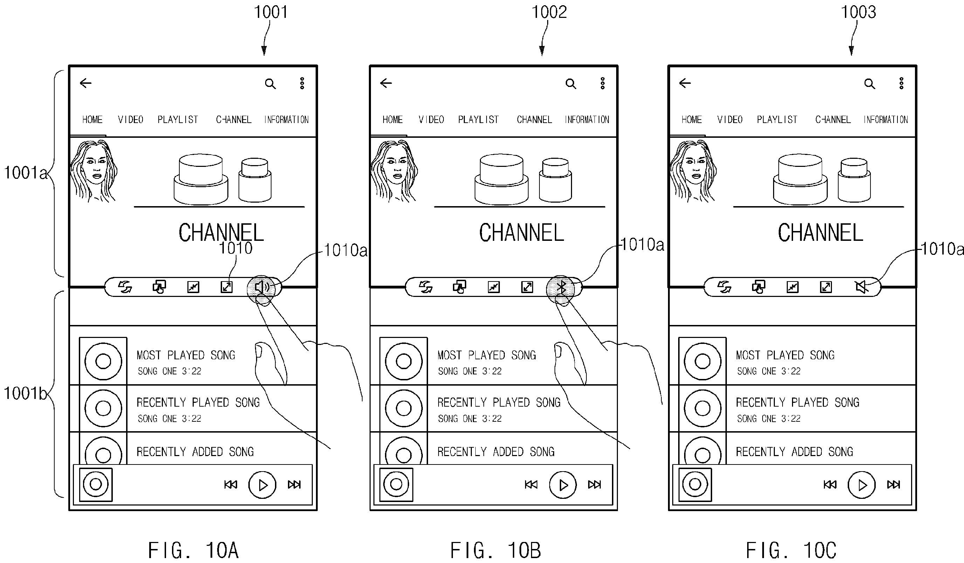

A process of changing a sound output method in a multi-window screen is described below with reference to FIGS. 10A to 12B.

FIGS. 10A-10C are illustrations of screens indicating a change of a sound output method in a multi-window screen, according to an embodiment of the present disclosure. However, the present disclosure is not limited thereto.

Referring to FIGS. 10A-10C, the processor 120 may output an execution screen of a first application in a first area 1001a (e.g., an upper area of a screen) and may output an execution screen of a second application in a second area 1001b (e.g., a lower area of the screen).

In an embodiment of the present disclosure, the processor 120 may output a UI 1010 for changing an execution manner of the first application and the second application. The UI 1010 may include a button 1010a for setting a sound output method of an application.

In screen 1001 (FIG. 10A), screen 1002 (FIG. 10B), and screen 1003 (FIG. 10C), in a case where a user repeatedly touches the button 1010a in the state where the first area 1001a is selected, the processor 120 may change a sound output method of the first application, based on the number of times that the user touches the button 1010a. Before the user presses the button 1010a, a sound of the first application may be set to be output through an internal speaker of the electronic device 101. In a case where the user presses the button 1010a once, the sound of the first application may be output through the external speaker that wirelessly operates in conjunction with the electronic device 101. In a case where the user presses the button 1010a twice, the sound of the first application may be set to be blocked.

In FIGS. 10A-10C, a process of changing a sound output method based on the button 1010a is disclosed. However, the present disclosure is not limited thereto. For example, according to a default setting, the processor 120 may allow a sound of an application to be output through an external speaker; in a case where a user repeatedly presses the button 1010a, the processor 120 may allow one of a plurality of speakers wirelessly operating with the electronic device 101 to be selected.

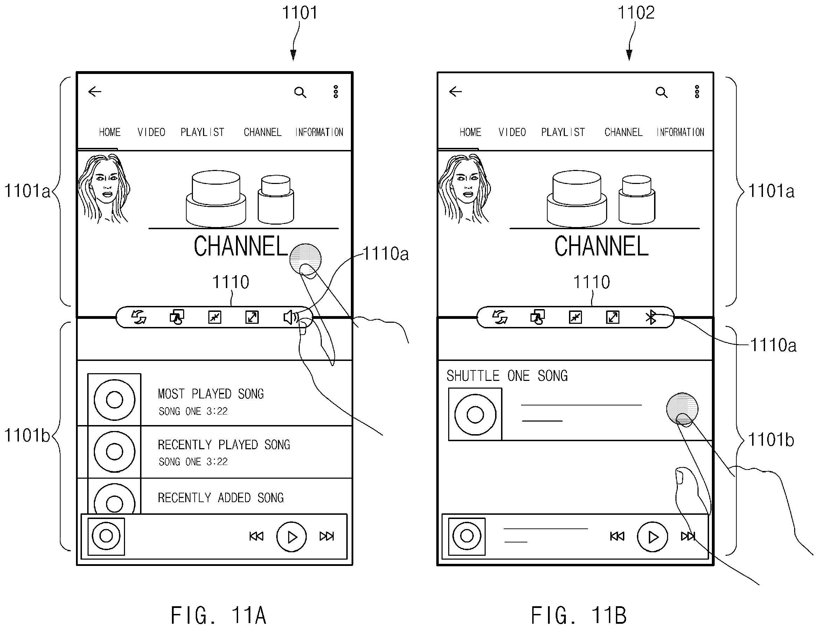

FIGS. 11A-11B are illustrations of screens indicating a change of a sound output method by selecting an area in a multi-window screen, according to an embodiment of the present disclosure. However, the present disclosure is not limited thereto.

Referring to FIGS. 11A-11B, in screens 1101 and 1102, the processor 120 may output an execution screen of a first application in a first area 1101a (e.g., an upper area of a screen) of the screen 1101 and may output an execution screen of a second application in a second area 1101b (e.g., a lower area of the screen) of the screen 1101.

In an embodiment of the present disclosure, the processor 120 may output a UI 1110 for changing an execution manner of the first application and the second application. The UI 1110 may include a button 1110a for setting a sound output method of an application.

In a case where a user executes a plurality of applications through a multi-window screen, the user may select (e.g., touch a corresponding area once) an area in which the user wants to control the sound output and may change a sound output method of an application running in an area selected by manipulating the button 1110a.

In the screen 1101 of FIG. 11A, in a case where the user selects the first area 1101a and manipulates the button 1110a, a sound output method of a first application running in the first area 1101a may be changed.

In the screen 1102 of FIG. 11B, in a case where the user selects the second area 1101b and manipulates the button 1110a, a sound output method of a second application being executed in the second area 1101b may be changed.

FIG. 11 is an example, and embodiments may not be limited thereto. For example, a first button may be output in the first area 1101a, and a second button may be output in the second area 1101b. If the user manipulates the first button, a sound output method of the first application of the first area 1101a may be changed. If the user manipulates the second button, a sound output method of the second application of the second area 1101b may be changed.

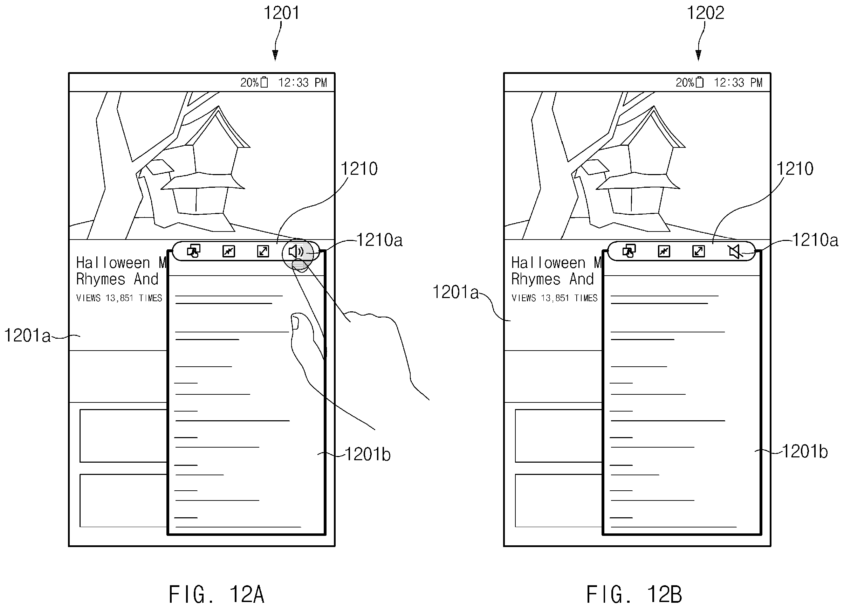

FIGS. 12A-12B are illustrations of a screen 1201 in FIG. 12A and a screen 1202 in FIG. 12B indicating a change of a sound output method in a multi-window screen of a picture-in-picture (PIP) manner, according to an embodiment of the present disclosure.

Referring to FIGS. 12A-12B, the processor 120 may output an execution screen in screen 1201 in FIG. 12A of a first application in a main screen (or a main window) 1201a and may output an execution screen of a second application in a sub-screen (or a sub-window) 1201b of a PIP manner.

According to an embodiment of the present disclosure, in a case where the sub-screen 1201b of the PIP manner is output based on a user manipulation, the processor 120 may output a UI 1210 for changing methods to execute the first application and the second application. The UI 1210 may include a button 1210a for setting a sound output method of an application.

In a case where the user selects the main screen 1201a and manipulates the button 1210a in screen 1201 in FIG. 12A, a sound output method of the first application that is running in the main screen 1201a may be changed. As in the above description, in a case where the user selects the sub-screen 1201b and manipulates the button 1210a in screen 1201 in FIG. 12A, a sound output method of the second application that is running in the sub-screen 1201b may be changed, as indicated in screen 1202 in FIG. 12B.

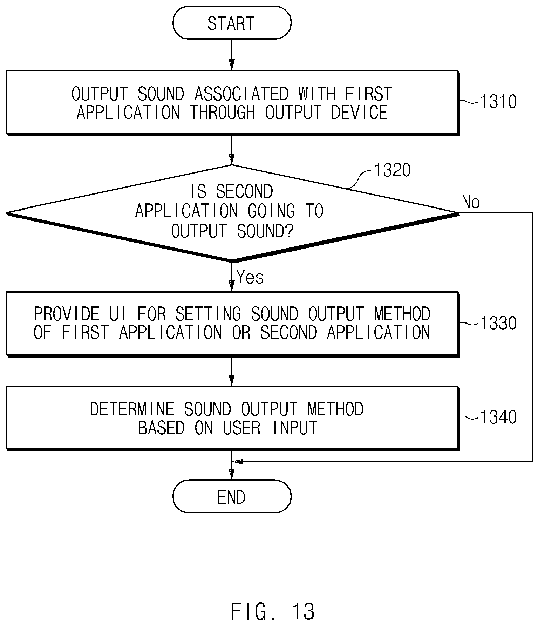

FIG. 13 is a flowchart of a process when a plurality of applications output sounds, according to an embodiment of the present disclosure.

Referring to FIG. 13, in step 1310, the processor 120 may execute a first application and may output a sound associated with the first application through an output device (e.g., an internal speaker or an external speaker).

In step 1320, a second application may be executed, and the processor 120 may verify whether the second application is going to output a sound.

If the second application is going to output a sound, in step 1330, the processor 120 may provide a user with a UI for setting a sound output method of the first application or the second application. For example, in the second application, a pop-up window for providing notification that a sound source to be played for a certain time or more is going to be output and determining whether to output the sound, and the sound output device may be output.

In step 1340, the processor 120 may determine a sound output method based on a user input. For example, the user may set whether to output a sound, a sound output level, a sound tone, a sound output device, and the like of the first application or the second application by manipulating a button included in a corresponding pop-up window.

According to an embodiment of the present disclosure, a sound outputting method executing in an electronic device, the method may include storing a sound output method based on at least one or more applications executing in the electronic device or categories of the applications, referring to a stored sound output method if an application is executing, determining sound output characteristic of an application or a sound output device associated with the application, based on the sound output method, and outputting a sound associated with the application by using the sound output device, based on the determined sound output characteristic.

According to an embodiment of the present disclosure, storing a sound output method may include providing a UI screen that allows a user to select the sound output method of an application.

According to an embodiment of the present disclosure, providing an UI screen may include outputting the UI screen if at least one of a user button input or recognition of an external device occurs.

According to an embodiment of the present disclosure, providing a UI screen may include outputting a list of applications being executed in an electronic device.

According to an embodiment of the present disclosure, providing a UI screen may include outputting a list of applications which use a sound source stored in an electronic device.

According to an embodiment of the present disclosure, providing a UI screen may include displaying a category based on classification of an app market from which the application is downloaded.

According to an embodiment of the present disclosure, providing a UI screen may include providing an option for setting whether to output a sound associated with an application, an output level of the sound associated with the application, and a tone of the sound associated with the application.

According to an embodiment of the present disclosure, storing of a sound output method may include storing the sound output method in an internal memory of an electronic device.

According to an embodiment of the present disclosure, determining a sound output device may include determining one of an internal speaker of an electronic device or an external speaker as the sound output device.

According to an embodiment of the present disclosure, storing a sound output method may include providing, if a plurality of applications are executing in a multi-window screen, a UI screen for selecting sound output methods of the plurality of applications between a first area and a second area of the multi-window screen.

According to an embodiment of the present disclosure, storing a sound output method may include storing sound output methods of a plurality of applications based on a number of times that a user manipulates a UI screen.

According to an embodiment of the present disclosure, storing a sound output method may include providing a UI screen for selecting sound output methods of a plurality of applications between a main screen and a sub-screen in a multi-window screen of a PIP manner.

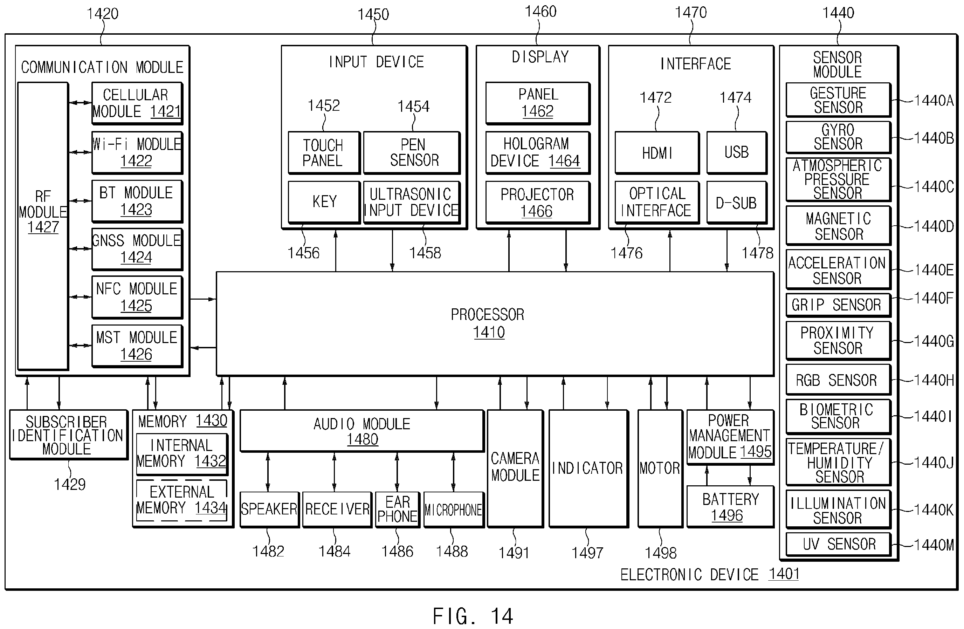

FIG. 14 is a block diagram of an electronic device according to an embodiment of the present disclosure. An electronic device 1401 may include, for example, all or a part of the electronic device 101 illustrated in FIG. 1. The electronic device 1401 may include one or more processors (e.g., an AP) 1410, a communication module 1420, a subscriber identification module 1429, a memory 1430, a sensor module 1440, an input device 1450, a display 1460, an interface 1470, an audio module 1480, a camera module 1491, a power management module 1495, a battery 1496, an indicator 1497, and a motor 1498.

The processor 1410 may drive an OS or an application to control a plurality of hardware or software elements connected to the processor 1410 and may process and compute a variety of data. The processor 1410 may be implemented with a system on chip (SoC), for example. According to an embodiment of the present disclosure, the processor 1410 may further include a graphics processing unit (GPU) and/or an image signal processor. The processor 1410 may include at least a part (e.g., a cellular module 1421) of elements illustrated in FIG. 14. The processor 1410 may load and process an instruction or data, which is received from at least one of other elements (e.g., a nonvolatile memory) and may store a variety of data in a nonvolatile memory.

The communication module 1420 may be configured the same as or similar to the communication interface 170 of FIG. 1. The communication module 1420 may include a cellular module 1421, a Wi-Fi module 1422, a Bluetooth (BT) module 1423, a GNSS module 1424 (e.g., a GPS module, a Glonass module, a Beidou module, or a Galileo module), an NFC module 1425, an MST module 1426 and a radio frequency (RF) module 1427.

The cellular module 1421 may provide voice communication, video communication, a message service, an Internet service or the like through a communication network. According to an embodiment of the present disclosure, the cellular module 1421 may perform discrimination and authentication of the electronic device 1401 within a communication network using the subscriber identification module (SIM) 1429 (e.g., a SIM card), for example. The cellular module 1421 may perform at least a portion of functions that the processor 1410 provides. The cellular module 1421 may include a CP.

Each of the Wi-Fi module 1422, the BT module 1423, the GNSS module 1424, the NFC module 1425, and the MST module 1426 may include a processor for processing data exchanged through a corresponding module, for example. At least a part (e.g., two or more elements) of the cellular module 1421, the Wi-Fi module 1422, the BT module 1423, the GNSS module 1424, the NFC module 1425, or the MST module 1426 may be included within one integrated circuit (IC) or an IC package.

The RF module 1427 may transmit and receive, for example, a communication signal (e.g., an RF signal). The RF module 1427 may include, for example, a transceiver, a power amplifier module (PAM), a frequency filter, a low noise amplifier (LNA), an antenna, or the like. According to another embodiment of the present disclosure, at least one of the cellular module 1421, the Wi-Fi module 1422, the BT module 1423, the GNSS module 1424, the NFC module 1425 or the MST module 1426 may transmit and receive an RF signal through a separate RF module.

The subscriber identification module 1429 may include, for example, a card and/or an embedded SIM and may include unique identity information (e.g., integrated circuit card identifier (ICCID)) or subscriber information (e.g., international mobile subscriber identity (IMSI)).

The memory 1430 (e.g., the memory 130 of FIG. 1) may include an internal memory 1432 or an external memory 1434. For example, the internal memory 1432 may include at least one of a volatile memory (e.g., a dynamic random access memory (DRAM), a static RAM (SRAM), or a synchronous DRAM (SDRAM)) and a nonvolatile memory (e.g., a one-time programmable read only memory (OTPROM), a programmable ROM (PROM), an erasable and programmable ROM (EPROM), an electrically erasable and programmable ROM (EEPROM), a mask ROM, a flash ROM, a flash memory (e.g., a NAND flash memory, or a NOR flash memory), a hard drive, or a solid state drive (SSD)).

The external memory 1434 may include a flash drive, for example, a compact flash (CF) drive, a secure digital (SD) drive, a micro secure digital (Micro-SD) drive, a mini secure digital (Mini-SD) drive, an extreme digital (xD) drive, a multimedia card (MMC), a memory stick, or the like. The external memory 1434 may be functionally and/or physically connected with the electronic device 1401 through various interfaces.

The sensor module 1440 may measure, for example, a physical quantity or may detect an operational state of the electronic device 1401. The sensor module 1440 may convert measured or detected information to an electrical signal. The sensor module 1440 may include at least one of a gesture sensor 1440A, a gyro sensor 1440B, an atmospheric pressure sensor 1440C, a magnetic sensor 1440D, an acceleration sensor 1440E, a grip sensor 1440F, a proximity sensor 1440G, a color sensor 1440H (e.g., a red, green, blue (RGB) sensor), a biometric sensor 14401, a temperature/humidity sensor 1440J, an illuminance sensor 1440K, or an ultra-violet (UV) light sensor 1440M. Additionally, or alternatively, the sensor module 1440 may include, for example, an electronic nose (E-nose) sensor, an electromyography (EMG) sensor, an electroencephalogram (EEG) sensor, an electrocardiogram (ECG) sensor, an infrared (IR) sensor, an iris sensor, and/or a fingerprint sensor. The sensor module 1440 may further include a control circuit for controlling at least one or more sensors included therein. According to an embodiment of the present disclosure, the electronic device 1401 may further include a processor which is a part of, or independent of, the processor 1410 and is configured to control the sensor module 1440. The processor may control the sensor module 1440 while the processor 1410 remains in a reduced power (e.g. sleep) state.

The input device 1450 may include, for example, a touch panel 1452, a (digital) pen sensor 1454, a key 1456, or an ultrasonic input unit 1458. The touch panel 1452 may use at least one of capacitive, resistive, infrared and ultrasonic detecting methods. In addition, the touch panel 1452 may further include a control circuit. The touch panel 1452 may further include a tactile layer to provide a tactile reaction to a user.

The (digital) pen sensor 1454 may be, for example, a portion of a touch panel or may include an additional sheet for recognition. The key 1456 may include, for example, a physical button, an optical key, a keypad, or the like. The ultrasonic input device 1458 may detect (or sense) an ultrasonic signal, which is generated from an input device, through a microphone 1488 and may check data corresponding to the detected ultrasonic signal.

The display 1460 (e.g., the display 160 in FIG. 1) may include a panel 1462, a hologram device 1464, or a projector 1466. The panel 1462 may be configured the same as or similar to the display 160 of FIG. 1. The panel 1462 may be implemented to be flexible, transparent or wearable, for example. The panel 1462 and the touch panel 1452 may be integrated into a single module. The hologram device 1464 may display a stereoscopic image in space using a light interference phenomenon. The projector 1466 may project light onto a screen so as to display an image. The screen may be arranged internal to or external of the electronic device 1401. According to an embodiment of the present disclosure, the display 1460 may further include a control circuit for controlling the panel 1462, the hologram device 1464, or the projector 1466.

The interface 1470 may include, for example, an HDMI 1472, a USB 1474, an optical interface 1476, or a D-subminiature (D-sub) connector 1478. The interface 1470 may be included, for example, in the communication interface 170 illustrated in FIG. 1. Additionally, or alternatively, the interface 1470 may include, for example, a mobile high definition link (MHL) interface, an SD card/multi-media card (MMC) interface, or an Infrared Data Association (IrDA) standard interface.

The audio module 1480 may convert a sound and an electrical signal in dual directions. At least a part of the audio module 1480 may be included, for example, in the input/output device 150 illustrated in FIG. 1. The audio module 1480 may process, for example, sound information that is input or output through a speaker 1482, a receiver 1484, an earphone 1486, or the microphone 1488.

The camera module 1491 for shooting a still image or a video may include, for example, at least one image sensor (e.g., a front sensor or a rear sensor), a lens, an image signal processor (ISP), or a flash (e.g., an LED or a xenon lamp).

The power management module 1495 may manage, for example, power of the electronic device 1401. According to an embodiment of the present disclosure, a power management integrated circuit (PMIC), a charger IC, or a battery gauge may be included in the power management module 1495. The PMIC may have a wired and/or a wireless charging method. The wireless charging method may include, for example, a magnetic resonance method, a magnetic induction method or an electromagnetic method and may further include an additional circuit, for example, a coil loop, a resonant circuit, a rectifier, or the like. The battery gauge may measure, for example, a remaining capacity of the battery 1496 and a voltage, current or temperature thereof while the battery is charged. The battery 1496 may include, for example, a rechargeable battery or a solar battery.

The indicator 1497 may display a certain state of the electronic device 1401 or a part thereof (e.g., the processor 1410), such as a booting state, a message state, a charging state, and the like. The motor 1498 may convert an electrical signal into a mechanical vibration and may generate a vibration effect, a haptic effect, or the like. A processing device (e.g., a GPU) for supporting a mobile TV may be included in the electronic device 1401. The processing device for supporting a mobile TV may process media data according to the standards of digital multimedia broadcasting (DMB), digital video broadcasting (DVB), MediaFloTM, or the like.

Each of the above-mentioned elements may be configured with one or more components, and the names of the elements may be changed according to the type of the electronic device. An electronic device according to an embodiment of the present disclosure may include at least one of the above-mentioned elements, but some elements may be omitted or other additional elements may be added. Furthermore, some of the elements of an electronic device according to an embodiment of the present disclosure may be combined with each other to form one entity, so that the functions of the elements may be performed in the same manner as before the combination.

According to an embodiment of the present disclosure, an electronic device may include a processor, a display configured to output a screen under control of the processor, a memory operatively connected with the processor, and a speaker module configured to output a sound, wherein the processor is configured to store a sound output method, which is based on at least one or more applications or categories of the applications, in the memory, if an application is executing, determine sound output characteristic of the application or a sound output device associated with the application, based on the sound output method, and output a sound associated with the application by using the sound output device, based on the determined sound output characteristic.

According to an embodiment of the present disclosure, a processor is configured to output a UI screen that allows a user to select a sound output method of an application in a display.

According to an embodiment of the present disclosure, a category is determined based on a classification of an app market from which an application is downloaded.

According to an embodiment of the present disclosure, a processor is configured to output a UI screen that includes an option for setting whether to output a sound associated with an application, an output level of a sound associated with the application, and a tone of the sound associated with the application, in a display.

According to an embodiment of the present disclosure, a processor is configured to determine one of a speaker module or an external speaker as a sound output device.

According to an embodiment of the present disclosure, a processor is configured to output, if a plurality of applications are executing in a multi-window screen, a UI screen for selecting sound output methods of the plurality of applications between a first area and a second area of the multi window screen.

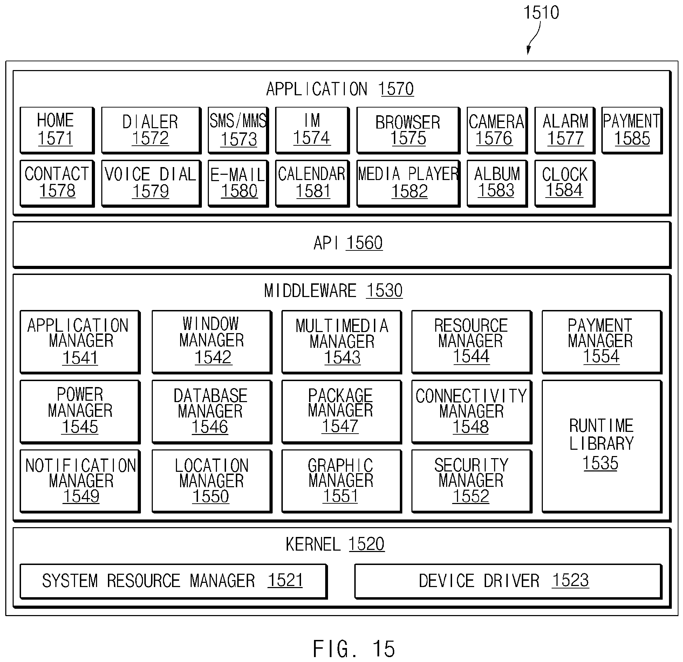

FIG. 15 is a block diagram of a program module according to an embodiment of the present disclosure. A program module 1510 (e.g., the program 140 of FIG. 1) may include an OS to control resources associated with an electronic device (e.g., the electronic device 101 of FIG. 1) and/or diverse applications (e.g., the application program 147 of FIG. 1) driven on the OS. The OS may be, for example, Android®, iOS®, Windows®, Symbian®, Tizen®, or Bada™.

The program module 1510 may include a kernel 1520, a middleware 1530, an application programming interface (API) 1560, and/or an application 1570. At least a part of the program module 1510 may be preloaded on an electronic device or may be downloadable from an external electronic device (e.g., the external device 102 of FIG. 1, and the like).

The kernel 1520 (e.g., the kernel 141 of FIG. 1) may include, for example, a system resource manager 1521 and/or a device driver 1523. The system resource manager 1521 may perform control, allocation, or retrieval of system resources. According to an embodiment of the present disclosure, the system resource manager 1521 may include a process managing part, a memory managing part, or a file system managing part. The device driver 1523 may include, for example, a display driver, a camera driver, a Bluetooth driver, a shared memory driver, a USB driver, a keypad driver, a Wi-Fi driver, an audio driver, or an inter-process communication (IPC) driver.

The middleware 1530 may provide, for example, a function which the application 1570 requires in common, or may provide diverse functions to the application 1570 through the API 1560 to allow the application 1570 to efficiently use limited system resources of an electronic device. According to an embodiment of the present disclosure, the middleware 1530 (e.g., the middleware 143 of FIG 1) may include at least one of a runtime library 1535, an application manager 1541, a window manager 1542, a multimedia manager 1543, a resource manager 1544, a power manager 1545, a database manager 1546, a package manager 1547, a connectivity manager 1548, a notification manager 1549, a location manager 1550, a graphic manager 1551, a security manager 1552, and a payment manager 1554.

The runtime library 1535 may include, for example, a library module which is used by a compiler to add a new function through a programming language while the application 1570 is being executed. The runtime library 1535 may perform input/output management, memory management, or capacities about arithmetic functions.

The application manager 1541 may manage, for example, a life cycle of at least one application of the application 1570. The window manager 1542 may manage a graphical user interface (GUI) resource which is used in a screen. The multimedia manager 1543 may identify a format necessary for playing diverse media files and may perform encoding or decoding of media files by using a codec suitable for the format. The resource manager 1544 may manage resources such as a storage space, memory, or source code of at least one application of the application 1570.

The power manager 1545 may operate, for example, with a basic input/output system (BIOS) to manage a battery or power and may provide power information for an operation of an electronic device. The database manager 1546 may generate, search for, or modify a database which is to be used in at least one application of the application 1570. The package manager 1547 may install or update an application which is distributed in the form of a package file.

The connectivity manager 1548 may manage, for example, a wireless connection such as Wi-Fi or Bluetooth. The notification manager 1549 may display or notify of an event such as an arrival message, an appointment, or a proximity notification in a mode that does not disturb a user. The location manager 1550 may manage location information of an electronic device. The graphic manager 1551 may manage a graphic effect that is provided to a user or manage a user interface relevant thereto. The security manager 1552 may provide a general security function necessary for system security or user authentication. The payment manager 1554 may manage payments made by an electronic device. According to an embodiment of the present disclosure, in a case where an electronic device (e.g., the electronic device 101 of FIG. 1) includes a telephony function, the middleware 1530 may further includes a telephony manager for managing a voice or video call function of the electronic device.

The middleware 1530 may include a middleware module that combines diverse functions of the above-described elements. The middleware 1530 may provide a module specialized to each OS type to provide differentiated functions. Additionally, the middleware 1530 may remove a part of preexisting elements, dynamically, or may add a new element thereto.

The API 1560 (e.g., the API 145 of FIG. 1) may be, for example, a set of programming functions and may be provided with a configuration which is variable depending on an OS. For example, in a case where an OS is Android® or iOS®, it may be permissible to provide one API set per platform. In a case where an OS is Tizen®, it may be permissible to provide two or more API sets per platform.

The application 1570 (e.g., the application program 147 of FIG. 1) may include, for example, one or more applications capable of providing functions for a home application 1571, a dialer application 1572, an short message service/multimedia messaging service (SMS/MMS) application 1573, an instant message (IM) application 1574, a browser application 1575, a camera application 1576, an alarm application 1577, a contact application 1578, a voice dial application 1579, an e-mail application 1580, a calendar application 1581, a media player application 1582, an album application 1583, a clock application 1584, and a payment application 1585 or for offering health care (e.g., measuring an exercise quantity or blood sugar level) or environmental information (e.g., atmospheric pressure, humidity, or temperature).

According to an embodiment of the present disclosure, the application 1570 may include an information exchanging application to support information exchange between the electronic device 101 of FIG. 1 and the electronic device 102 or 104 of FIG. 1. The information exchanging application may include, for example, a notification relay application for transmitting certain information to an external electronic device, or a device management application for managing the external electronic device.

For example, the notification relay application may include a function of transmitting notification information, which arise from other applications (e.g., applications for SMS/MMS 1573, e-mail 1580, health care, or environmental information), to the electronic device 102 or 104 of FIG. 1. Additionally, the notification relay application may receive, for example, notification information from an external electronic device and provide the notification information to a user.

The device management application may manage (e.g., install, delete, or update), for example, at least one function (e.g., turn-on/turn-off of an external electronic device (or a part of components) or adjustment of brightness (or resolution) of a display) of the electronic device 102 of FIG. 1 which communicates with an electronic device 101, an application running in the external electronic device, or a service (e.g., a call service, a message service, or the like) provided from the external electronic device.

According to an embodiment of the present disclosure, the application 1570 may include an application (e.g., a health care application of a mobile medical device, and the like) which is assigned in accordance with an attribute of the electronic device 102 of FIG. 1. The application 1570 may include an application which is received from the electronic device 102 of FIG. 1. The application 1570 may include a preloaded application or a third party application which is downloadable from a server. The element titles of the program module 1510 may be modifiable depending on OS type.

According to an embodiment of the present disclosure, at least a part of the program module 1510 may be implemented by software, firmware, hardware, or a combination of two or more thereof. At least a portion of the program module 1510 may be implemented (e.g., executed), for example, by the processor (e.g., the processor 110 of FIG. 1). At least a portion of the program module 1510 may include, for example, a module, a program, a routine, sets of instructions, or a process for performing one or more functions.

The term "module" used in the present disclosure may indicate, for example, a unit including one or more combinations of hardware, software and firmware. For example, the term "module" may be interchangeably used with the terms "unit", "logic", "logical block", "component" and "circuit". The term "module" may indicate a minimum unit of an integrated component or may be a part thereof. The term "module" may indicate a minimum unit for performing one or more functions or a part thereof. The term "module" may indicate a device implemented mechanically or electronically. For example, the term "module" may indicate a device that includes at least one of an application-specific IC (ASIC), a field-programmable gate array (FPGA), and a programmable-logic device for performing some operations, which are known or will be developed.

At least a portion of an apparatus (e.g., modules or functions thereof) or a method (e.g., operations) according to an embodiment of the present disclosure may be, for example, implemented by instructions stored in a non-transitory computer-readable storage media in the form of a program module. The instruction, when executed by a processor (e.g., the processor 120 of FIG. 1), may cause one or more processors to perform a function corresponding to the instruction. A non-transitory computer-readable storage media, for example, may be the memory 130 of FIG. 1.

A non-transitory computer-readable storage media according to an embodiment of the present disclosure may store a program for executing an operation in which a communication module receives an application package from an external device and provides the application package to a non-secure module of a processor, an operation in which the non-secure module determines whether a secure application is included in at least a portion of the application package, and an operation in which a secure module of the processor installs the secure application in the secure module or in a memory associated with the secure module.

A non-transitory computer-readable storage media may include a hard disk, a floppy disk, a magnetic media (e.g., a magnetic tape), an optical media (e.g., a compact disc read only memory (CD-ROM) and a digital versatile disc (DVD)), a magneto-optical media (e.g., a floptical disk), and hardware devices (e.g., a ROM, a RAM, or a flash memory). In addition, a program instruction may include not only a mechanical code such as things generated by a compiler but also a high-level language code executable on a computer using an interpreter. The above-mentioned hardware devices may be configured to operate as one or more software modules to perform operations according to an embodiment of the present disclosure, and vice versa.

Modules or program modules according to an embodiment of the present disclosure may include at least one or more of the above-mentioned elements, where some of the above-mentioned elements may be omitted, or other additional elements may be further included therein. Operations executed by modules, program modules, or other elements may be executed by a successive method, a parallel method, a repeated method, or a heuristic method. In addition, a part of operations may be executed in different sequences, omitted, or other operations may be added.

According to an embodiment of the present disclosure, the user may set the different sound output methods based on applications executing in the electronic device such that the sound of an application is output through an output device that the user selects.

According to an embodiment of the present disclosure, a user may select sound output characteristics (e.g., whether to output a sound, a sound output level, a tone, and the like) of an application and sound output devices (e.g., an internal speaker, an external speaker, and the like) by providing a UI screen in which the user sets different sound output methods, based on each application or a category of each application.

The above embodiments of the present disclosure are illustrative and not limitative. Various alternatives and equivalents are possible. Other additions, subtractions, or modifications are obvious in view of the present disclosure and are intended to fall within the scope of the appended claims.

While the present disclosure has been shown and described with reference to various embodiments thereof, it will be understood by those skilled in the art that various changes in form and details may be made therein without departing from the scope of the present disclosure as defined by the appended claims.

## Claims

1. A sound outputting method executed in an electronic device, the method comprising:
storing (210) a sound output information based on a first application and a second application being executed in the electronic device or categories of the first application and the second application;
referring (220) to the stored sound output information if the first application and the second application are executing in a multi-window screen, wherein the first application is displayed in a first area of the multi-window screen and the second application is displayed in a second area of the multi-window screen;
providing a user interface, UI, screen for changing the sound output information of the first application and the second application between the first area and the second area;
determining (230) a sound output device associated with the first application or the second application, based on the sound output information; and
outputting (240) a sound associated with the first application or the second application by using the sound output device, wherein the sound output device is one of an internal speaker of the electronic device or an external speaker.

2. The method of claim 1, wherein providing the UI screen comprises:
outputting the UI screen if at least one of a user button input or recognition of an external device occurs.

3. The method of claim 1, wherein providing the UI screen comprises:
outputting a list of applications being executed in the electronic device.

4. The method of claim 1, wherein providing the UI screen comprises:
outputting a list of applications which use a sound source stored in the electronic device.

5. The method of claim 1, wherein providing the UI screen comprises:
displaying a category based on classification of a category of an application applied to an application, app, market from which the executing application is downloaded.

6. The method of claim 1, wherein providing the UI screen comprises:
providing an option for setting whether to output the sound associated with the executing application, an output level of the sound associated with the executing application, and a tone of the sound associated with the executing application.

7. The method of claim 1, wherein storing the sound output information comprises:
storing the sound output information in an internal memory of the electronic device.

8. The method of claim 1, wherein providing the UI screen comprises:
changing the sound output information based on a user input to change the sound output information.

9. An electronic device, comprising:
a processor (120);
a display (160) configured to output a screen under control of the processor;
a memory (130) operatively connected with the processor; and
a speaker module (180) configured to output a sound,
wherein the processor is configured to:
store a sound output information, which is based on a first application and a second application or categories of the first application and the second application, in the memory, if the first application and the second application are executing in a multi-window screen, providing a user interface, UI, for changing the sound output information of the first application and the second application, wherein the first application is displayed in a first area of the multi-window screen and the second application is displayed in a second area of the multi-window screen, wherein the user interface, UI, is displayed between the first area and the second area,
determine a sound output device associated with the first application or the second application, based on the sound output information, and
output a sound associated with the first application or the second application by using the sound output device, wherein the sound output device is one of the speaker module of the electronic device or an external speaker.

10. The electronic device of claim 9, wherein the processor is further configured to output the UI screen that includes an option for setting whether to output a sound associated with the first application or the second application, an output level of the sound associated with the first application or the second application, and a tone of the sound associated with the first application or the second application, in the display.

## Patentansprüche

1. Audioausgabeverfahren, das in einer elektronischen Vorrichtung ausgeführt wird, wobei das Verfahren Folgendes umfasst:
Speichern (210) von Audioausgabeinformationen basierend auf einer ersten Anwendung und einer zweiten Anwendung, die in der elektronischen Vorrichtung ausgeführt werden, oder Kategorien der ersten Anwendung und der zweiten Anwendung;
Beziehen (220) auf die gespeicherten Audioausgabeinformationen, wenn die erste Anwendung und die zweite Anwendung in einem Mehrfachfensterbildschirm ausgeführt werden, wobei die erste Anwendung in einem ersten Bereich des Mehrfachfensterbildschirms angezeigt wird und die zweite Anwendung in einem zweiten Bereich des Mehrfachfensterbildschirms angezeigt wird;
Bereitstellen eines UI(Benutzeroberfläche)-Bildschirms zum Ändern der Tonausgabeinformationen der ersten Anwendung und der zweiten Anwendung zwischen dem ersten Bereich und dem zweiten Bereich;
Bestimmen (230) einer Audioausgabevorrichtung, die der ersten Anwendung oder der zweiten Anwendung zugewiesen ist, basierend auf den Tonausgabeinformationen; und
Ausgeben (240) eines Audios, das der ersten Anwendung oder der zweiten Anwendung zugewiesen ist, unter Verwendung der Audioausgabevorrichtung, wobei die Audioausgabevorrichtung ein interner Lautsprecher der elektronischen Vorrichtung oder ein externer Lautsprecher ist.

2. Verfahren nach Anspruch 1, wobei das Bereitstellen des UI-Bildschirms Folgendes umfasst:
Ausgeben des UI-Bildschirms, wenn mindestens eine Benutzerschaltflächeneingabe und/oder eine Erkennung einer externen Vorrichtung auftritt.

3. Verfahren nach Anspruch 1, wobei das Bereitstellen des UI-Bildschirms Folgendes umfasst:
Ausgeben einer Liste von Anwendungen, die in der elektronischen Vorrichtung ausgeführt werden.

4. Verfahren nach Anspruch 1, wobei das Bereitstellen des UI-Bildschirms Folgendes umfasst:
Ausgeben einer Liste von Anwendungen, die eine Audioquelle verwenden, die in der elektronischen Vorrichtung gespeichert ist.

5. Verfahren nach Anspruch 1, wobei das Bereitstellen des UI-Bildschirms Folgendes umfasst:
Anzeigen einer Kategorie basierend auf Klassifizierung einer Kategorie einer Anwendung, die auf einen Anwendungs(App)-Markt angewendet wird, von dem die ausführende Anwendung heruntergeladen wird.

6. Verfahren nach Anspruch 1, wobei das Bereitstellen des UI-Bildschirms Folgendes umfasst:
Bereitstellen einer Option zum Einstellen, ob das Audio, das der ausführenden Anwendung zugewiesen ist, eine Ausgabeebene des Audios, das der ausführenden Anwendung zugewiesen ist, und ein Ton des Audios, das der ausführenden Anwendung zugewiesen ist, ausgegeben werden soll.

7. Verfahren nach Anspruch 1, wobei das Speichern der Audioausgabeinformationen Folgendes umfasst:
Speichern der Audioausgabeinformationen in einem internen Speicher der elektronischen Vorrichtung.

8. Verfahren nach Anspruch 1, wobei das Bereitstellen des UI-Bildschirms Folgendes umfasst:
Ändern der Audioausgabeinformationen basierend auf einer Benutzereingabe, um die Audioausgangsinformationen zu ändern.

9. Elektronische Vorrichtung, umfassend:
einen Prozessor (120);
eine Anzeige (160), die zum Ausgeben eines Bildschirms unter Kontrolle des Prozessors konfiguriert ist;
einen Speicher (130), der operativ mit dem Prozessor verbunden ist, und
ein Lautsprechermodul (180), das zum Ausgeben eines Audios konfiguriert ist,
wobei der Prozessor für Folgendes konfiguriert ist:
Speichern von Audioausgabeinformationen, die auf einer ersten Anwendung und einer zweiten Anwendung oder Kategorien der ersten Anwendung und der zweiten Anwendung basieren, in dem Speicher,
wenn die erste Anwendung und die zweite Anwendung in einem Mehrfachfensterbildschirm ausgeführt werden, Bereitstellen einer Benutzeroberfläche, UI, zum Ändern der Audioausgabeinformationen der ersten Anwendung und der zweiten Anwendung, wobei die erste Anwendung in einem ersten Bereich des Mehrfachfensterbildschirms angezeigt wird und die zweite Anwendung in einem zweiten Bereich des Mehrfachfensterbildschirms angezeigt wird, wobei die Benutzeroberfläche, UI, zwischen dem ersten Bereich und dem zweiten Bereich angezeigt wird,
Bestimmen einer Audioausgabevorrichtung, die der ersten Anwendung oder der zweiten Anwendung zugewiesen ist, basierend auf den Audioausgabeinformationen, und
Ausgeben eines Audios, das der ersten Anwendung oder der zweiten Anwendung zugewiesen ist, unter Verwendung der Audioausgabevorrichtung, wobei die Audioausgabevorrichtung das Lautsprechermodul der elektronischen Vorrichtung oder ein externer Lautsprecher ist.

10. Elektronische Vorrichtung nach Anspruch 9, wobei der Prozessor ferner konfiguriert ist, um den UI-Bildschirm auszugeben, der eine Option zum Einstellen einschließt, ob ein Audio, das der ersten Anwendung oder der zweiten Anwendung zugewiesen ist, eine Ausgabeebene des Audios, das der ersten Anwendung oder der zweiten Anwendung zugewiesen ist, und ein Ton des Audios, das der ersten Anwendung oder der zweiten Anwendung zugewiesen ist, auf der Anzeige ausgegeben werden soll.

## Revendications

1. Procédé d'émission de son exécuté dans un dispositif électronique, le procédé comprenant :
stocker (210) des informations de sortie audio sur la base d'une première application et d'une deuxième application en cours d'exécution dans le dispositif électronique ou des catégories de la première application et de la deuxième application ;
se référer (220) aux informations de sortie audio stockées si la première application et la deuxième application s'exécutent dans un écran multi-fenêtre, où la première application est affichée dans une première zone de l'écran multi-fenêtre et la deuxième application est affichée dans une deuxième zone de l'écran multi-fenêtre ;
fournir un écran d'interface utilisateur, UI, pour changer les informations de sortie audio de la première application et de la deuxième application entre la première zone et la deuxième zone ;
déterminer (230) un dispositif de sortie audio associé à la première application ou à la deuxième application, sur la base des informations de sortie audio ; et
émettre (240) un son associé à la première application ou à la deuxième application en utilisant le dispositif de sortie audio, où le dispositif de sortie audio est l'un parmi un haut-parleur interne du dispositif électronique ou un haut-parleur externe.

2. Procédé selon la revendication 1, où la fourniture de l'écran UI comprend :
délivrer en sortie l'écran UI si au moins l'une parmi une entrée de bouton d'utilisateur ou une reconnaissance d'un dispositif externe se produit.

3. Procédé selon la revendication 1, où la fourniture de l'écran UI comprend :
délivrer en sortie une liste d'applications en cours d'exécution dans le dispositif électronique.

4. Procédé selon la revendication 1, où la fourniture de l'écran UI comprend :
délivrer en sortie une liste d'applications qui utilisent une source sonore stockée dans le dispositif électronique.

5. Procédé selon la revendication 1, où la fourniture de l'écran UI comprend :
afficher une catégorie sur la base d'une classification d'une catégorie d'une application appliquée à un marché d'applications, app, à partir duquel l'application d'exécution est téléchargée.

6. Procédé selon la revendication 1, où la fourniture de l'écran UI comprend :
fournir une option permettant de définir s'il faut émettre le son associé à l'application d'exécution, un niveau de sortie du son associé à l'application d'exécution et une tonalité du son associée à l'application d'exécution.

7. Procédé selon la revendication 1, où le stockage des informations de sortie audio comprend :
stocker les informations de sortie audio dans une mémoire interne du dispositif électronique.

8. Procédé selon la revendication 1, où la fourniture de l'écran UI comprend :
changer les informations de sortie audio sur la base d'une entrée d'utilisateur pour changer les informations de sortie audio.

9. Dispositif électronique, comprenant :
un processeur (120) ;
une unité d'affichage (160) configurée pour délivrer en sortie un écran sous la commande du processeur ;
une mémoire (130) connectée de manière fonctionnelle au processeur, et
un module de haut-parleur (180) configuré pour émettre un son,
où le processeur est configuré pour :
stocker des informations de sortie audio, qui sont basées sur une première application et une deuxième application ou des catégories de la première application et de la deuxième application, dans la mémoire,
si la première application et la deuxième application s'exécutent dans un écran multi-fenêtre, fournir une interface utilisateur, UI, pour changer les informations de sortie audio de la première application et de la deuxième application, où la première application est affichée dans une première zone de l'écran multi-fenêtre et la deuxième application est affichée dans une deuxième zone de l'écran multi-fenêtre, où l'interface utilisateur, UI, est affichée entre la première zone et la deuxième zone,
déterminer un dispositif de sortie audio associé à la première application ou à la deuxième application, sur la base des informations de sortie audio, et
émettre un son associé à la première application ou à la deuxième application en utilisant le dispositif de sortie audio, où le dispositif de sortie audio est l'un parmi le module de haut-parleur du dispositif électronique ou un haut-parleur externe.

10. Dispositif électronique selon la revendication 9, où le processeur est configuré, en outre, pour délivrer en sortie l'écran UI qui comprend une option permettant de définir s'il faut émettre un son associé à la première application ou à la deuxième application, un niveau de sortie du son associé à la première application ou à la deuxième application et une tonalité du son associé à la première application ou à la deuxième application, dans l'unité d'affichage.
